Europäisches Patentamt

European Patent Office

Office européen des brevets

(11) Publication number: **0 232 601**
A1

## (12) EUROPEAN PATENT APPLICATION

(21) Application number: 86309258.1

(22) Date of filing: 27.11.86

(51) Int. Cl.⁴: **C 23 C 14/34,** C 23 C 14/24, G 03 F 7/26, C 23 F 1/00

(30) Priority: 02.12.85 GB 8529654

(43) Date of publication of application: 19.08.87
Bulletin 87/34

(84) Designated Contracting States: AT BE CH DE FR IT LI LU NL SE

(71) Applicant: PLESSEY OVERSEAS LIMITED, Vicarage Lane, Ilford Essex IGI 4AQ (GB)

(72) Inventor: Morgan, Peter John, Rockwell International, Dallas Texas (US)
Inventor: Moseley, Andrew Jonathan, 18 Calvert Close Greens Norton, Towcester Northants (GB)

(74) Representative: Field, Howard John, THE PLESSEY COMPANY plc Vicarage Lane, Ilford Essex IG1 4AQ (GB)

(54) Method of coating.

(57) A method of coating for defining wire bond and solder bond pads on the side facets of a submount block (5). A substrate (23) of insulating material is coated on its front face (17) with metal and channels (33, 35) are cut into this face (17) to define the sidewalls of an array of blocks. The substrate (23) is coated with a layer of dry film resist (37) by e.g. a hot vacuum technique, windows (41, 39) over the channels (33, 35) defined, and metal deposited. Further metal is then added by plating, the surrounding metal coating removed, and the blocks (5) separated by cutting from the reverse side of the substrate (23).

-1-

## METHOD OF COATING

### Technical Field

The present invention concerns improvements in or relating to methods of coating, in particular methods suitable for the application of a metal coating to the multifacets of miniature blocks and the like.

Metal coated miniature blocks have application, inter alia, to photodetector submount assembly in the manufacture of optical receivers. Side facets of these blocks have metal pad areas for wire and solder bonding. Integrity is required between these pads and corresponding metal on the front faces of these blocks.

### Background Art

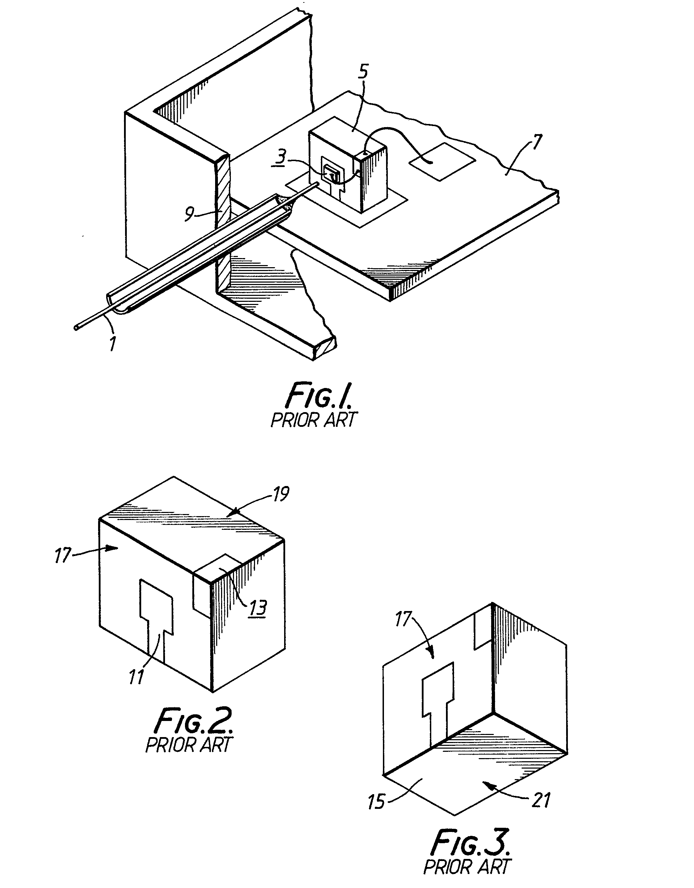

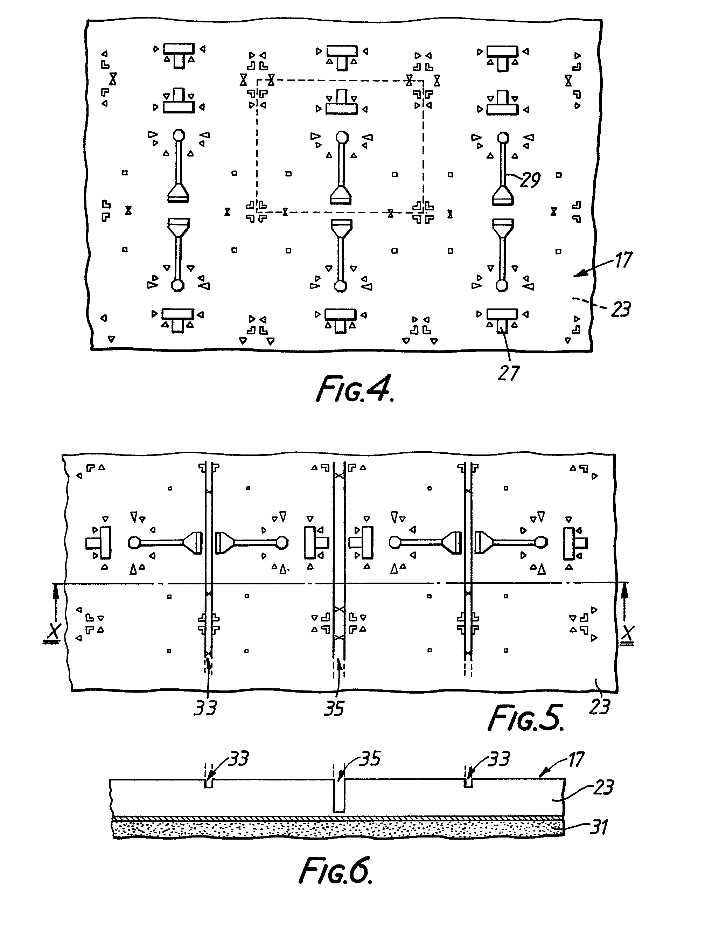

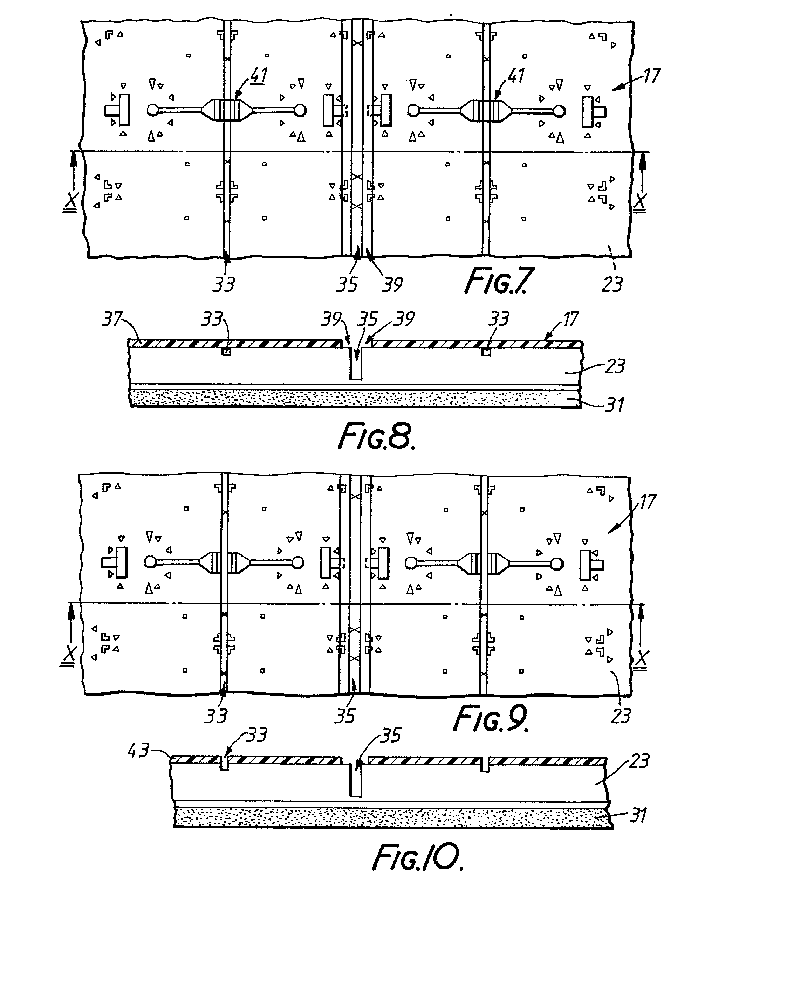

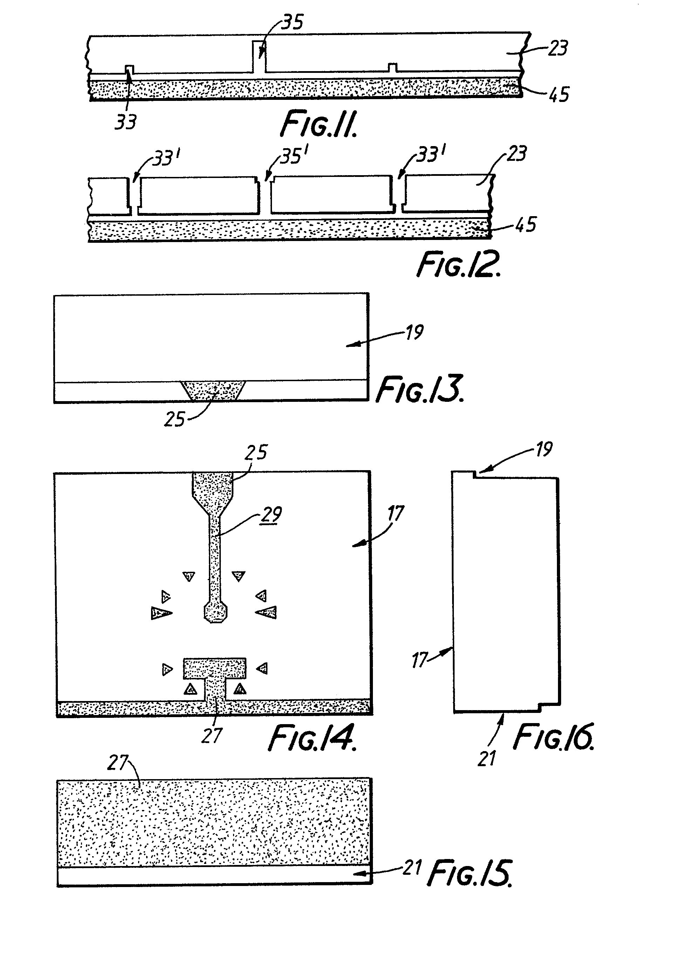

The favoured method , for optically coupling an optical fibre 1 to an optical detector 3 is to submount the optical detector 3 (either a P.I.N photodiode, APD or phototransistor) on a miniature block 5. This assembly is then attached to a hybrid circuit 7 in such a way that the photodetector 3 is aligned at right angles to the hybrid circuit 7 (see Fig.1). The optical fibre 1 is then aligned through a module package wall 9 to the photodetector 3 and fixed into position. Hitherto, the photodetector submount block 5 has been produced using alumina, as the base material, and thick film inks to form conduction tracks 11, wire-bonding and solder-bonding

-2-

pads 13, 15 (Figs 2 and 3). Although the pattern on the front face 17 of the block 5 is achieved by screen printing, in an array, the wire bond pad 13 on the top surface 19 and the solder bond pad 15 on the underside 21 are defined by hand painting each individual block 5. For optical receivers operating up to 140 Mbits/sec, the add-on capacitance associated with the ceramic photodiode (PD.) block has been acceptable. However for higher data rate receivers (eg. 565 Mbits/sec) the value of the add-on capacitance (typically 60 fF) is unacceptably large. A significant factor contributing to the capacitance of the PD. block is the permittivity of the base material of the block 5. For alumina the relative permittivity is typically 10. By using quartz, with a relative permittivity of 3.8, instead of alumina, a significant reduction of capacitance could be realised. A further contributory factor to the capacitance is the size of the wire bond pad 13 which ideally should be as small as possible. However using hand painting, suitably small and consistant wire bond pads are not possible.

Disclosure of the Invention

The method of this invention is intended to provide well defined geometrical coatings for multifaceted miniature submount blocks and the like, and uses planar processing techniques.

This method is applicable to the manufacture of miniature photodetector submount blocks, and, by eliminating need for hand painting, permits control and minimisation of add-on capactiance.

In accordance with the invention thus there is provided a method of coating including the following steps:-

applying a primary coating of one or more metals to the front face of an insulating substrate;

cutting one or more channels into the front face of the substrate;

covering the coated surface of the substrate with a layer of dry film resist;

opening one or more windows in the photoresist, each window lying over a channel and exposing the coated metal each side of the window;

depositing metal through each window into the underlying channel to coat the side walls thereof;

plating metal onto the coated channel side walls, removing the primary coating of the one or more metals;

cutting into each channel from the reverse face of the substrate; and,

separating the substrate into blocks.

Where, in the method aforesaid, each window is of large size, the resist may be removed following plating.

Where however, in the method aforesaid, one or more of the windows is of small size, it is preferable to remove the resist before plating, to apply a second layer of dry film resist and to open one or more windows extending to full length of each channel, to afford thus full exposure to electrolyte during plating. This second layer is then removed after plating.

Where the substrate is of delicate material, it is preferable that the dry film resist is applied by a hot, vacuum technique.

It is preferable that the channel side walls are coated by sputtering metal.

The steps of the method aforesaid may include a step during which electrode structure on the front face of the substrate is provided by plating through a resist mask.

The substrate may be of quartz or other low permittivity material. The blocks may be used as optical detector submounts in high data rate optical receivers.

Brief Introduction of the Drawings

In the drawings accompanying this specification:-

Figure 1 is a cut-away assembly showing a known submount block wired and solder bonded to an hybrid circuit;

Figures 2 and 3 show different perspective views of the submount block;

Figure 4 is a plan view of the front face of a quartz substrate the surface of which has been metallised and patterned plated pads and tracks defined;

Figures 5 and 6 show in plan view and in cross-section respectively, the quartz substrate following channel definition;

Figures 7 and 8 show in plan view and in cross-section respectively, the quartz substrate following first resist bonding and windows definition;

Figures 9 and 10 show in plan view and in cross-section respectively, the quartz substrate following second bonding and channel exposure;

Figure 11 and 12 are cross-sections of the substrate after remounting and cutting, respectively;

Figures 13 and 16 shown in rear elevation, plan-view, front elevation and side elevation, a block cut from the substrate at conclusion of this process; and

Figure 17 is an illustrative drawing showing apparatus used for hot vacuum bonding.

Description of Preferred Embodiment

So that this invention may be better understood, an embodiment thereof will now be described, and reference will be made to the drawings, aforesaid. The description of the process that follows is given by way of example only.

In the process, thus, the following steps are performed:-

1.    One of the major faces 17 of a quartz substrate 23 is metallised with suitable metals.  In this case an initial layer of chromium (to provide good adhesion to the quartz, though other metals such as tungsten or titanium could be used) of approximate thickness 50 nm.  is deposited, followed by 100 nm. of gold.  Various techniques are avilable for the deposition of the metals such as electron-beam evaporation or sputtering.

2.    Bonding pads 25, 27 and interconnection track pattern 29 are now defined, in an array on the initial layers deposited on the quartz substrate 23.  This is accomplished with conventional photolithography and electroplating.  (Fig.4.)

3.    The quartz substrate 23 is then mounted on a support substrate, such as a silicon wafer 31.  This is accomplished by using a suitable wax, in this case glycol phthalate, to bond the quartz to the support substrate 31. The quartz 23 is bonded down such that the metallised face 17, is uppermost.

4.    Channels 33 and 35 are then cut into the quartz substrate.  These channels 33 and 35 define the top and bottom edges 19 and 21 to the PD. blocks 5.  The depth of the channels 33 and 35 define the extent of metallisation. Accurate control of the channel depth is therefore essential. As a specific example, using a 600 micron thick quartz substrate, deep channels 35 of 500 microns are cut which define the underside 21 of the PD. blocks and shallow channels 33 of 150 microns (which define the depth of the wire bond pads 25 on the top edge 19). Exact dimensional details can be readily varied. (see Figs. 5 and 6).

5. It is necessary in this process to metallise into the channels 33 and 35 and to define the extent of metallisation. It is not possible to use conventional liquid photoresists to define geometrical patterns on substrates with narrow channels and protrusions present, since a uniform conformal coating is not in general possible.

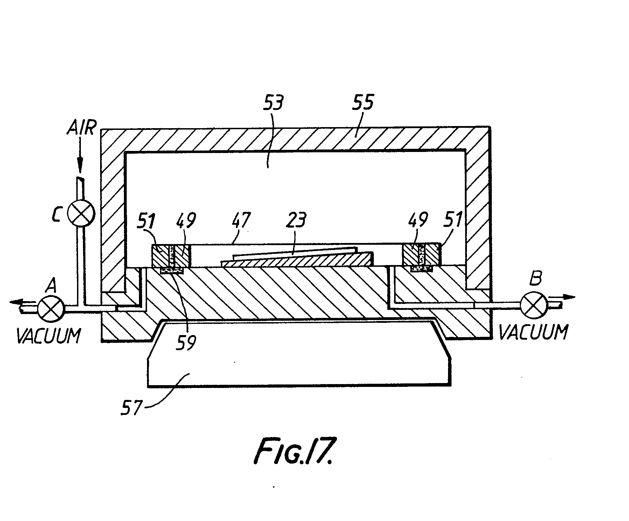

However, a material commonly used in the printed circuit industry is dry film photoresist, a material which is available commercially. Dry film photoresist has normally been applied to printed circuit boards with hot rollers. The resist is known to provide a good uniform conformal coating for PCB's, covering protrusions and "tenting" over voids such as through holes. The features of tenting over the voids, and, coverage of protrusions, are properties required for the quartz substrates 23 produced herein. The method of application normally used (hot rollers) is not suitable however for applying dry film photoresist to small and delicate substrates, such as the quartz substrates considered here. However a method has been developed now for applying dry film photoresist to delicate substrates. This employs a hot, vacuum bonding process (see fig. 17 and discussion later). Next process step is the application of dry film photoresist 37 to the quartz substrate 23 and the development of an appropriate image. For this example the image developed is such that a strip 39 of the photoresist film 37, directly above the deep channels 35 is removed and windows 41 opened in the resist 37 over the shallow channels 33 (figs. 7 and 8).

6. The channels 33 and 35 in the quartz substrate 23 are then metallised, preferably by sputtering which gives good coating of the side walls of the channels 33 and 35. The deep channels 35 are fully coated with deposited metals (chromium/platinum/gold). The shallow channels 33 are metallised only in the regions directly under the windows 41 in the photoresist 37. The photoresist layer 37 is then removed.

7. A second application of dry film photoresist 43 is made and an image developed in the photoresist to expose both the deep and shallow channels 35 and 33. (see fig.9 and 10).

8. The exposed metal layers in the channels 33 and 35 are then plated-up with gold in an electroplating bath. The dry film photoresist 43 is then removed.

9. The primary metallisation layers of chromium and gold are then removed by etching.

10. The quartz substrate 23 is then demounted from the support substrate 31 and remounted face-down (ie flipped over) upon another support substrate 45 (fig. 11).

11. Channels 33 and 35 are then cut through from the back-face to the channels 33 and 35 on the front face 17 (fig.12). a slightly wider blade than that used to cut the initial front face channels 33 and 35 is prefered in order to ensure that there is a step-down from the metallisation. (A step-up would interfere with wire bonding and soldering operations). Orthogonal through cuts are then made to complete the dicing operation.

A completed PD. block 5 is shown in figs. 13 to 16. The particular block shown is adapted to mount a reverse entry P.I.N. photodiode. However, other devices may readily be accomodated with suitable alternative metallisation patterns.

As mentioned at step 5 of the above process, dry film photoresist is applied to the quartz substrate 23 by a hot, vacuum bonding technique (see fig. 17). Dry film photoresist is available in rolled sheet form. The photoresist film itself is usually sandwiched between two polymer protective films. A section of suitable size is cut from the sheet and the polymer film on the inside of the rolled sheet removed.  The photoresist film is then stretched over a metal frame 49 and retained by a fitted outer metal frame 51.  Excess sheet material is trimmed off.

The quartz substrate 23 is placed in a vacuum chamber 53 upon a supporting wedge 55.  The photoresist film 47, supported by the metal frames 49 and 51 is then placed above the substrate 23 and the cover 55 of the chamber 53 placed in position.  The substrate is then raised to a suitable temperature (typically $100 \pm 5^{\circ}C$ as recommended) by means of a hot-plate 57 to effect bonding.  The chamber 53 is then evacuated to a minimum 70 cm Hg. vacuum by opening a first valve, valve A, to vacuum.  A second valve, valve B, is then opened and the space enclosed by the metal frames 49,51 and film 47 evacuated.  The frames 49,51 bear down on a ring seal 59 to ensure that the enclosed space is made airtight. Valve A is then closed and the outer space of the chamber 53 allowed to approach atmospheric pressure slowly.  As the pressure is increased, the photoresist film is urged onto the surface 17 of the substrate 23, with which it then forms a bond.  Air is then admitted to the chamber, by opening a third valve, valve C. Valve B is closed and the whole allowed to attain atmospheric pressure throughout before removal of the substrate 23.

0232601

## CLAIMS

1. A method of coating including applying a primary coating of one or more metals to the front face (17) of an insulating substrate (23);

cutting one or more channels (33, 35) into the front face (17) of the substrate (23);

covering the coated surface (17) of the substrate (23) with a layer of dry film resist (37);

opening one or more windows (39, 41) in the resist (37), each window (39, 41) lying over a channel (33) and exposing the coating metal each side of the window (39, 41);

depositing metal through each window (39, 41) into the underlying channel (33) to coat the side walls thereof;

plating metal onto the coated channel side walls, removing the primary coating of the one or more metals;

cutting into each channel (33, 35) from the reverse face of the substrate(23); and,

separating the substrate (23) into blocks (5).

2. A method, as claimed in claim 1, wherein following deposition of metal through each window (39, 41) and preceding plating, the layer of dry film resist (37) is removed, a second layer of dry film resist (43) applied, and channel length windows defined.

3. A method, as claimed in either claims 1 or 2, wherein the dry film resist (37, 43) is applied by a hot vacuum technique.

4. A method, as claimed in any one of the preceding claims, wherein the metal deposited (25, 27) is provided by sputtering.

5. A method, as claimed in any one of the preceding claims, wherein electrode structure (25, 27, 29) on the front face (17) of the substrate (23) is provided by plating using a resist mask.

1/5

0232601

**FIG.1.**
PRIOR ART

**FIG.2.**
PRIOR ART

**FIG.3.**
PRIOR ART

*Fig.4.*

*Fig.5.*

*Fig.6.*

*Fig.7.*

*Fig.8.*

*Fig.9.*

*Fig.10.*

*35*

*23*

*45*

*33*

**Fig.11.**

*33'* *35'* *33'* *23*

*45*

**Fig.12.**

*19*

**Fig.13.**

*25*

*25*

*29*

*17*

*27*

**Fig.14.**

*19*

*17*

*21*

**Fig.16.**

*27*

*21* **Fig.15.**

Fig.17.

## European Patent Office

## EUROPEAN SEARCH REPORT

Application number

| DOCUMENTS CONSIDERED TO BE RELEVANT | EP 86309258.1 |
| --- | --- |

| Category | Citation of document with indication. where appropriate, of relevant passages | Relevant to claim | CLASSIFICATION OF THE APPLICATION (Int. Cl.4) |
| --- | --- | --- | --- |
| X | EP - A2 - 0 064 744 (SIEMENS AKTIENGESELLSCHAFT) <br> * Claim 1 * <br> -- | 1,3-5 | C 23 C 14/34 <br> C 23 C 14/24 <br> G 03 F 7/26 <br> C 23 F 1/00 |
| A | DE - A1 - 3 443 233 (ARMSTRONG WORLD INDUSTRIES LTD.) <br> * Abstract * <br> -- | 1,2 | |
| A | DE - A1 - 3 401 963 (SIEMENS AG) <br> * Claims 1,4 <br> -- | 1-3 | |
| A | PATENT ABSTRACTS OF JAPAN, unexamined applications, C field, vol. 8, no. 131, July 17, 1982 <br> THE PATENT OFFICE JAPANESE GOVERNMENT <br> page 146 C 114 <br> * Kokai no. 57-57 872 (FUJITSU K.K.) * <br> ---- | 1 | TECHNICAL FIELDS SEARCHED (Int. Cl.4) <br><br> C 23 C <br> G 03 F |

The present search report has been drawn up for all claims

| Place of search | Date of completion of the search | Examiner |
| --- | --- | --- |
| VIENNA | 05-03-1987 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82